Europäisches Patentamt

(19) European Patent Office (11) Veröffentlichungsnummer: **0 092 555**

Office européen des brevets **B1**

(12) **EUROPÄISCHE PATENTSCHRIFT**

(45) Veröffentlichungstag der Patentschrift: **12.09.90** (51) Int. Cl.⁵: **G 08 B 13/24, H 01 F 17/00**

(21) Anmeldenummer: **82903167.3**

(22) Anmeldetag: **29.10.82**

(86) Internationale Anmeldenummer:
**PCT/DE82/00210**

(87) Internationale Veröffentlichungsnummer:
**WO 83/01697 11.05.83 Gazette 83/11**

(54) **IDENTIFIZIERUNGSANORDNUNG IN FORM EINES AN EINEM GEGENSTAND ANBRINGBAREN ETIKETTS.**

(30) Priorität: **30.10.81 DE 3143208**

(43) Veröffentlichungstag der Anmeldung:
**02.11.83 Patentblatt 83/44**

(45) Bekanntmachung des Hinweises auf die
Patenterteilung:
**12.09.90 Patentblatt 90/37**

(84) Benannte Vertragsstaaten:
**AT BE CH DE FR GB LI LU NL SE**

(56) Entgegenhaltungen:
**GB-A-2 000 382**
**US-A-2 851 765**
**US-A-3 810 147**

**Patent Abstract of Japan, vol 5, no 30, 24
February 1981, page E-47(702) & JP A 55156311
Internationale Elektronische Rundschau, vol 26,
no 5, May 1972 (Berlin DE) "Hochstabile
gedruckte Spulen mit hohen Induktivitäts
werten", page 112**

(73) Patentinhaber: **REEB, Max E.**
**Helfensteinstrasse 7**
**D-7336 Uhingen (DE)**

(72) Erfinder: **REEB, Max E.**
**Helfensteinstrasse 7**
**D-7336 Uhingen (DE)**

EP 0 092 555 B1

Courier Press, Leamington Spa, England.

**Beschreibung**

Die Erfindung betrifft eine Identifizierungsanordnung in Form eines an einem Gegenstand anbringbaren Etiketts, welches wenigstens ein aus flächenhaften Leiterbahnen gebildetes induktives Element und ein aus übereinander angeordneten Leiterbahnen und einem dazwischengefügten Dielektrikum gebildetes kapazitives Element enthält, das mit dem induktiven Element einen Resonanzkreis bildet.

Die Erfindung betrifft ferner ein Verfahren zur Herstellung einer Identifizierungsanordnung in Form eines an einem Gegenstand anbringbaren Etiketts, welches wenigstens ein aus flächenhaften Leiterbahnen gebildetes induktives Element und ein aus übereinander angeordneten Leiterbahnteilen und einem dazwischengefügten Dielektrikum gebildetes kapazitives Element enthält, das mit dem induktiven Element einen Resonanzkreis bildet.

Die Erfindung betrifft schließlich eine Verwendung der oben bezeichneten Identifizierungsanordnung zur Entdeckung von Warendiebstählen.

Eine Identifizierungsanordnung der eingangs genannten Art ist aus der DE—A—24 23 002 bekannt. Ähnliche Anordnungen sind in der US—A—3 810 147 sowie der GB—A—2 000 382 beschrieben.

Die bekannten Anordnungen, insbesondere gemäß DE—A—25 23 002, enthalten einen aus flächenhaften Leiterbahnen bestehenden Resonanzkreis, der aus diskreten Elementen aufgebaut ist. Hierunter versteht main einen Resonanzkreis, bei dem die induktiven und die kapazitiven Elemente des Ersatzschaltbildes exakt räumlichen Strukturen der Anordnung zugeordnet werden können. So besteht die bekannte Anordnung gemäß DE—A—25 23 002 beispielsweise aus einem Resonanzkreis mit zwei induktiven und zwei kapazitiven Elementen, wobei die beiden induktiven Elemente durch zwei getrennte flächenhafte, spiralförmige Leiterbahnen gebildet werden, während die kapazitiven Elemente durch jeweils zwei Paare einander in zwei Ebenen gegenüberstehender Leiterflächen gebildet werden.

Zur Herstellung der erforderlichen diskreten induktiven Elemente ist es bekannt, diese auf flächenartigen Körpern vorzusehen, wie dies beispielsweise in Patents Abstract of Japan Vol. 5, Nr. 30 vom 24.2. 1981, in der US—A—2 851 765 sowie in der Zeitschrift "Internationale Elektronische Rundschau", Vol. 26, Nr. 5, Mai 1972, Seite 112, beschrieben ist.

So weist beispielsweise die in der US—A—3 810 147 beschriebene Identifizierungsanordnung induktive und kapazitive Elemente auf, die in der Technik gedruckter Leiterplatten durch metallische Leiterbahnen bzw. Leitflächen auf zwei übereinanderliegenden Substratplatten gebildet werden. Die kapazitiven Elemente bestehen dabei aus insgesamt drei Paaren von rechteckförmigen Leitflächen, die auf jeweils beiden Substraten angeordnet sind, während die induktiven Elemente durch spiralförmig angeordnet Leiterbahnen gebildet werden, die beide nur auf einem der beiden Substrate angeordnet sind.

Die induktiven Elemente einerseits und die kapazitiven Elemente andererseits sind bei dieser bekannten Identifizierungsanordnung somit räumlich voneinander getrennt und nur aus Platzgründen relativ nahe beieinander angeordnet. Eine elektrische Wechselwirkung zwischen diesen Leiterbahnen bzw. Leitflächen über elektromagnetische Felder ist weder vorgesehen noch beabsichtigt.

Wenn derartige Anordnungen in sehr großer Stückzahl benötigt werden, spielen für die wirtschaftliche Anwendung des Systems die Herstellungskosten eine wesentliche Rolle. Werden beispielsweise die Leiterbahnen auf beiden Seiten einer Trägerfolie ausgebildet, so ist es zur Herstellung galvanischer Verbindungen zwischen den Leiterbahnen oder Leitflächen beider Seiten erforderlich, eine Durchkontaktierung durch die Trägerfolie hindurch vorzunehmen. Dies gilt vor allem im Hinblick auf die induktiven Elemente, die bei den bekannte Identifizierungsanordnungen, wie dies weiter oben anhand der US—A—3 810 147 beschrieben wurde, als diskretes Bauelement in Gestalt einer spiralförmig verlaufenden Leiterbahn nur auf einem der Substrate angeordnete sind. Hier sind galvanische Verbindungen zwischen den beiden Seiten der Trägerfolie zwingend erforderlich, um den gewünschten Schwingkreis herzustellen.

Andererseits ist bei den bekannten Anordnungen mit diskret verteilten Elementen auch im Bereich der kapazitiven Elemente mit Schwierigkeiten zu rechnen, wenn die Paßgenauigkeit der Leitflächen auf beiden Seiten der Folie zueinander nicht exakt gewährleistet werden kann. Es ergeben sich dann nämlich merkliche Verschiebungen in den Kapazitätswerten der kapazitiven Elemente und damit Streuungen in der Resonanzfrequenz des insgesamt gebildeten resonanzfähigen Systems.

Aufgabe der Erfindung ist die Schaffung einer Identifizierungsanordnung und eines Verfahrens zu seiner Herstellung, die eine kostengünstige Massenherstellung ermöglichen, so daß die Identifizierungsanordnungen für einmaligen Gebrauch geeignet sind. Ferner sollen die Identifizierungsanordnungen trotz der kostengünstigen Massenherstellungstechnik geringe Toleranzen und einen hohen Zuverlässiggrad aufweisen.

Diese Aufgabe wird gemäß der eingangs genannten Anordnung erfindungsgemäß dadurch gelöst, daß die Leiterbahnen als Streifenleitung ausgebildet sind, bei der die das kapazitive Element bildenden Leiterbahnen mindestens teilweise mit Leiterbahnen identisch sind, welche das induktive Element bilden.

Gemäß dem eingangs genannten Verfahren wird diese Aufgabe erfindungsgemäß dadurch gelöst, daß ein in einer Ebene abwickelbares Leiterbahngebilde längs wenigstens einer Faltlinie so zusammengefaltet wird, daß zwischen wenigstens zwei aufeinander gefalteten Leiterbahnteilen ein Dielektrikum eingefügt wird.

Schließlich wird die vorstehend genannten Anordnung erfindungsgemäß auch an einem Warenauszeichnungsetikett angeordnet oder das Warenauszeichnungsetikett weist einen Kundenabschnitt und einen mit diesem lösbar verbundenen Kassenabschnitt auf und die Identifizierungsanordnung ist wenigstens in einem der beiden Abschnitte angeordnet.

Die der Erfindung zugrundeliegende Aufgabe wird auf diese Weise vollkommen gelöst.

Die Vorteile der vorstehend genannten erfindungsgemäßen Anordnung bestehen vor allem darin, daß bei Verwendung von Streifenleitungen ein wesentlichen größerer Freiheitsgrad hinsichtlich der Durchkontaktierungen besteht, weil bekanntlich Streifenleitungen aus Elementen bestehen, die über elektromagnetische Wellen miteinander in Wirkverbindung stehen. Es ist daher bei derartigen Streifenleitungen grundsätzlich nicht erforderlich, galvanische Verbindungen zwischen einzelnen Substraten herzustellen, weil es eine Eigenheit von Streifenleitungen ist, daß sich nicht aus diskreten Bauelementen—die einer Verdrahtung mit galvanischen Verbindungen bedürften—sondern vielmehr aus infinitesimal verteilten Elementen, nämlich den sogenanten Kapazitätsbelägen und Induktivitätsbelägen bestehen. Außerdem hat sich gezeigt, daß Streifenleitungen der hier interessierenden Art wesentlich weniger anfällig im Hinblick auf Ungenauigkeiten bei der Passung sind, weil die Resonanzfrequenz der Streifenleitung, verglichen mit dem Fall der aus diskreten Bauelementen ausgebauten herkömmlichen Schwingskreise, weniger ändert, wenn die Leitflächen nicht exact zueinander ausgerichtet werden.

Das genannte erfindungsgemäße Herstellungsverfahren hat den Vorteil, daß unabhängig davon, in welcher Form die Resonanzanordnung aufgebaut ist, eine hochgenaue Passung von Leiterbahnen und insbesondere Leitflächen erzielt werden kann, wenn eine Trägerfolie durch Falten zu einem resonanzfähigen Gebilde gemacht wird, das hinsichtlich der Trägerfolie einstückig ist, so daß beim Falten der Trägerfolie weniger Störungen hinsichtlich der Passung der aufeinandergefalteten Leitflächen auftreten können, als dies bei zwei unabhängigen Folien oder Substraten der Fall wäre, die unabhängig voneinander an einen Montageort gebracht und dort zusammengefügt werden.

Dem erfindungsgemäßen Verfahren liegt also der Gedanke zugrunde, die Windungen des induktiven Elementes durch Zusammenfalten eines Leiterbahngebildes übereinander anzuordnen, so daß die Anzahl der Windungen praktisch unbegrenzt ist und die erforderlichen verteilten Kapazitäten durch selektives Einfügen von dielektrischen Schichten zwischen aufeinandergefalteten Leiterbahnteilen hergestellt werden können. Da die Leiterbahnen äußerst dünn ausgebildet sein können, kann bei sehr geringer Dicke der gesamten Identifizierungsanordnung ein ausreichend großer Induktivitäts- und Kapazitätswert erreicht werden. Die Identifizierungsanordnung kann

daher sehr flexibel ausgebildet und insbesondere wie ein herkömmliches Papier-, Kunststoff- oder Pappetikett verarbeitet werden. Da die einzelnen Leiterbahnen bzw. Leitflächen direkt übereinander angeordnet sein können, wird eine ausgezeichnete magnetische Kopplung zwischen den einzelnen Leiterbahnen erreicht, so daß sich geringe Streuinduktivitäten und dadurch genau einhaltbare Transformationsverhältnisse der verteilten Kapazitäten zur gesamtwirksamen Schwingkreiskapazität ergeben.

Die erfindungsgemäße Identitizierungsanordnung kann sehr flexibel ausgebildet und insbesondere wie ein herkömmliches Papier-, Kunststoff- oder Pappetikett verarbeitet werden.

Bei eine besonders bevorzugten Ausgestaltung der Erfindung haben die Leiterbahnen in den einander überlagerten Flächen jeweils voneinander verschiedene Formen und/oder Abmessungen, insbesondere unterschiedliche Breiten.

Diese Maßnahme hat den Vorteil, daß Parallelverschiebungen innerhalb der Herstellungstoleranzen möglich sind, ohne die Resonanzfrequenz des Streifenleitungs-Resonators zu verändern.

Ausführungsbeispiele der Erfindung sind in der Zeichnung dargestellt und werden nachstehend anhand der Beschreibung näher erläutert. Es zeigen:

Fig. 1 eine schematische Ansicht eines in eine Ebene abgewickelten Leiterbahngebildes, das nach geeignetem Zusammenfalten ein induktives Element ergibt;

Fig. 2 eine Schnittansicht einer üblichen Streifenleitung;

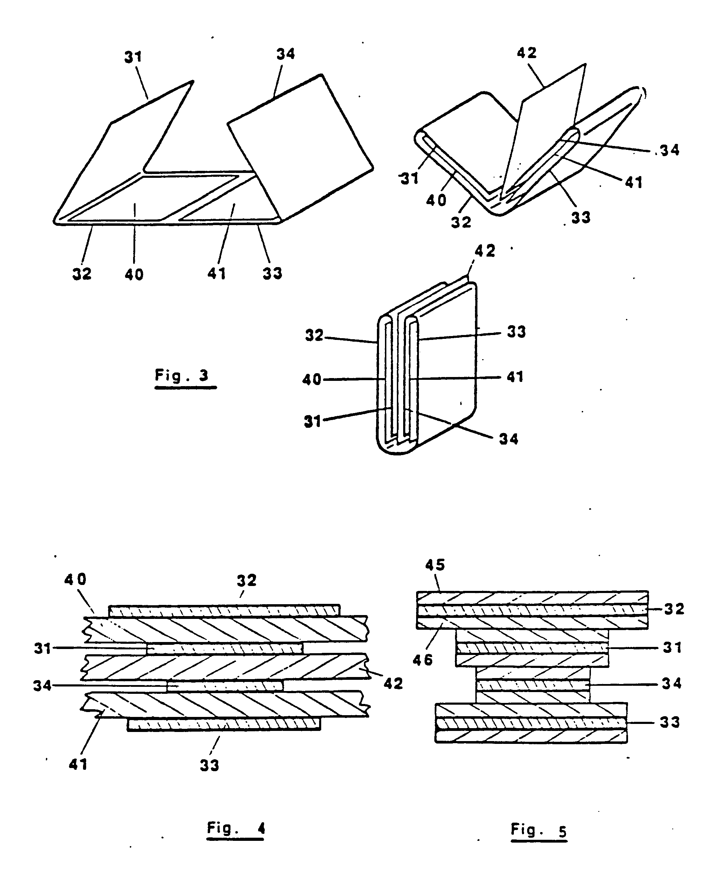

Fig. 3 mehrere schematische Ansichten zur Erläuterung des Zusammenfaltens des Leiterbahngebildes gemäß Fig. 1;

Fig. 4 und 5 Teilschnittansichten durch das in Fig. 3 gezeigte zusammengefaltete Gebilde;

Fig. 6 ein Ersatzschaltbild des in den Fig. 3 bis 5 gezeigten elektrischen Bauteils, das einen Parallelresonanzkreis bildet;

Fig. 7 eine Draufsicht auf eine Trägerfolie, die mehrere Leiterbahngebilde zur Herstellung von Identifizierungsanordnungen trägt;

Figs. 8, 9 und 10 schematische Ansichten zur Erläuterung weiterer Ausführungsformen der Erfindung, die einen Abgleich des kapazitiven Elements im Verlauf des Herstellungsverfahrens ermöglichen;

Fig. 11 eine Schnittansicht durch eine randnahe Zone einer fertigen, in eine Schutsfolie eingesiegelten Identifizierungsanordnung;

Fig. 12 eine schematische Ansicht einer zu einer Vorratsrolle aufgerollten Trägerfolie, in die eine Vielzahl von fertigen elektrischen Identifizierungsanordnungen eingesiegelt ist und die selbsthaftend ausgebildet ist;

Fig. 13 eine Draufsicht auf ein in eine Ebene abgewickeltes Leiterbahngebilde zur Herstellung einer nach außen abgeschirmten Identifizierungsanordnung mit vier einander überlagerten Ebenen und erhöhter Induktivität;

Fig. 14 eine Draufsicht auf ein Leiterbahngebilde zur Herstellung einer Identifizierungsanordnung mit acht oder mehr einander überlagerten Faltebenen;

Figs. 15 und 16 schematische Ansichten zur Erläuterung der Herstellung einer Identifizierungsanordnung mit nur zwei Faltebenen;

Figs. 17 und 18 schematische Ansichten zur Erläuterung einer Ausführungsform, bei der zwischen zwei einander überlagerten Ebenen nur eine kapazitive Kopplung vorhanden ist;

Fig. 19 ein Ersatzschaltbild der Ausführungsform nach den Figuren 17 und 18;

Fig. 20 eine schematische Ansicht zur Erläuterung des Abgleichs des kapazitiven Elements bei der Ausführungsform nach den Figuren 17 und 18 mittels eines dielektrischen Abgleichbandes;

Fig. 21 eine schematische Draufsicht auf einen streifenförmigen Träger, der abwechselnd je ein mit einer Identifizierungsanordnung versehenes Feld und eine freies Feld aufweist;

Fig. 22 eine auseinandergezogene Darstellung zur Erläuterung, wie eine erfindungsgemäße Identifizierungsanordnung an einem zu sichernden Gegenstand befestigt werden kann;

Fig. 23 eine auseinandergezogene Darstellung einer anderen Ausführungsform zur Befestigung einer Identifizierungsanordnung an einem zu sichernden Gegenstand.

Das Kernstück der erfindungsgemäßen Identizierungsanordnung ist ein elektrisches Bauteil, das einen Parallelresonanzkreis darstellt und aus einem induktiven Element sowie verteilten Kapazitäten gebildet ist. Im folgenden wird zunächst dieses elektrisches Bauteil beschrieben.

Da die beschriebene Identizierungsanordnung besonders schnell und einfach, aber auch mit geringstmöglichem Abfall an Rohmaterial hergestellt werden kann, kommt sie ganz besonders zur Ausrüstung von Warenauszeichnungs- und Sicherungsetiketten in Betracht.

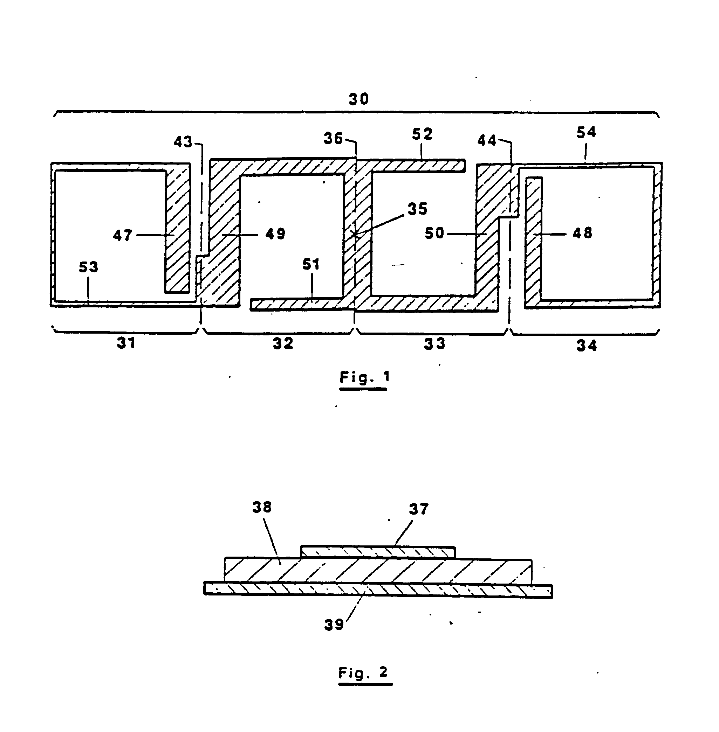

Aus einer dünnen Metallfolie, die ein- oder zweiseitig bereits mit geeigneten dielektrischen Belägen untrennbar beschichtet sein kann, wird eine ebenes Gebilde 30 mit einer Leiterbahnstruktur gemäß Fig. 1 hergestellt. Eine wesentliche Eigenschaft des aus vier zusammenhängenden Teilstrukturen 31 bis 34 (im folgenden als Blätter bezeichnet und in einfachen Skizzen auch als geschlossene Blätter dargestellt) bestehenden Leiterbahngebildes ist, daß es zwar zum Mittelpunkt 35 zentralsymmetrisch angelegt scheint, jedoch alle bezüglich der Achse 36 sich symmetrisch gegenüberliegenden Leiterbahnteile unterschiedliche Breiten aufweisen, so daß sich symmetrische Paare in der Breite jeweils nur um einen Breitensprung unterscheiden. Zur Erläuterung zeigt Fig. 2 den Querschnitt durch eine Streifenleitung, bestehend aus einer Wellenleiterbahn 37, einem Dielektrikum konstanter Dicke 38 und einer Massefläche 39, die ausgedehnter als die Breite der Wellenleiterbahn 37 ist. Wird die Wellenleiterbahn 37 seitlich verschoben, so ändert dies deren Kapazitätzbelag nicht. Wird das in Fig. 1 gezeigte Leiterbahngebilde aus unbeschichteter Metallfolie gefertigt, so wird dieses nun entsprechend der vereinfachten Skizze in Fig.

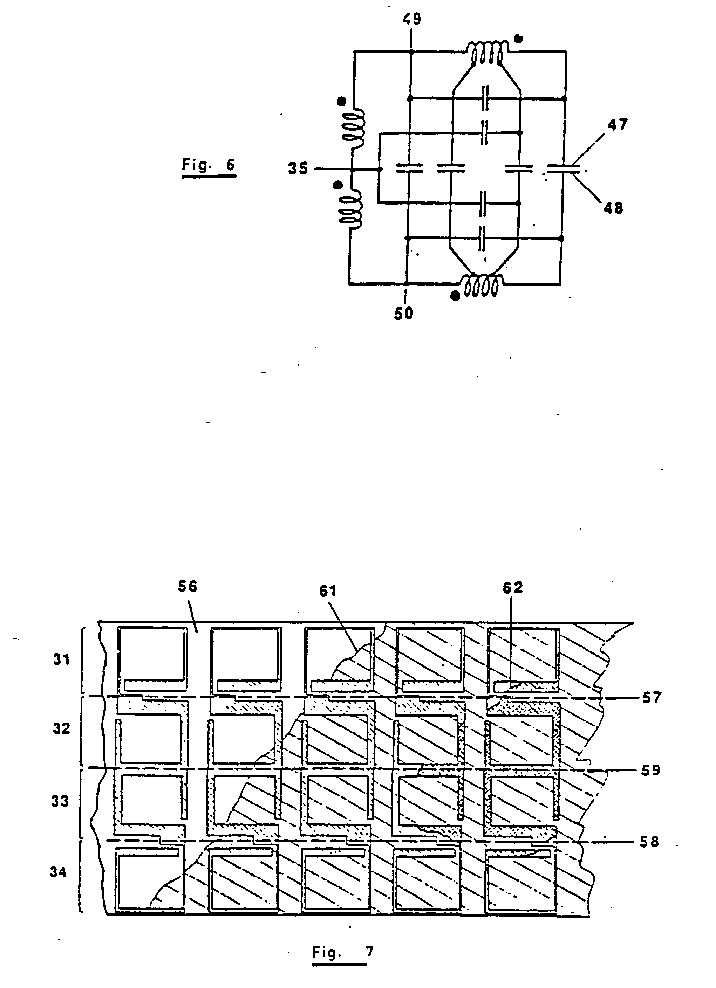

3 unter Einfügung der dielektrischen Beläge 40, 41 und 42 entlang den Faltlinien 43, 44 bzw. der Achse 36 in Fig. 1 zusammengefaltet, so daß sich ein Querschnitt durch einen beliebigen Teil des Randes der zusammengefalteten Anordnung gemäß Fig. 4 ergibt. Wird das in Fig. 1 gezeigte Leiterbahngebilde aus einer Metallfolie gefertigt, die bereits vorweg mit geeigneten dielektrischen Belägen 45 und 46 kaschiert ist, so entfällt das Einfügen der Beläge 40, 41 und 42, und es ergibt sich nach dem analogen Faltvorgang ein entsprechendes Querschnittsbild gemäß Fig. 5, insgesamt also ein Gebilde mit viereckiger Struktur und durchbrochenem Innern.

In beiden Fällen entsteht ein Thomsonscher Schwingungskreis mit einer Schwingkreiskapazität, die sich aus der Transformation verteilter Leitungskapazitäten und konzentrierter Kapazitäten der Leiterbahnteile 47 gegen 48, 47 gegen 49 und 48 gegen 50 zusammensetzt. Das Gebilde kann in erster Näherung durch die Ersatzschaltung gemäß Fig. 6 beschrieben werden; einander entsprechende Teile und Orte sind dort mit denselben Bezugszeichen wie in Fig. 1 bezeichnet.

Die unterschiedliche Breite in zusammengefaltetem Zustand jeweils übereinanderliegender Leiterbahnen leistet mehreres:

a) Ungenauigkeiten beim Übereinanderpositionieren der einzelnen Blätter ändern die Kapazität zwischen jeweils übereinander verlaufenden Leiterbahnteilen kaum, solange nur eine Positioniertoleranz innerhalb geometrisch einfach bestimmbarer und vorschreibbarer Grenzwerte eingehalten wird. Dieser Effekt kann genutzt werden, solange die Breite der Leiterbahnen viel größer als die Dicke der dielektrischen Trennschichten ist und das elektrisches Feld zwischen Metallbelägen somit überwiegend homogen verläuft. Als Ergebnis ist die wirksame Schwingkreiskapazität gegenüber Positionierungsungenauigkeiten beim Zusammenfalten innerhalb Deckungstoleranzgrenzen praktisch invariant und hängt hauptsächlich von der Maßgenauigkeit der Leiterbahnen und von Eigenschaften des Dielektrikums.

b) Da die Leiterbahnen sich gegenseitig abdekken, des weiteren die Breite der Leiterbahnen wesentlichen größer als die Dicke der isolierenden Trennschichten zwischen den Windungen der Spule ist, ist die Kopplung der räumlich verteilten Windungen sehr fest und die Streuinduktivität derselben gegeneinander sehr gering. Daraus resultieren sehr konstante Transformationsverhältnisse für die einzelnen verteilten Leitungskapazitäten.

c) Nach dem Zusammenfalten liegen die Blätter 32 und 33 mit niedriger Impedanz bezogen auf den Strukturmittelpunkt 35 gemäß Fig. 1 bzw. den Spulenmittelpunkt 35 gemäß Fig. 6 auf der Außenseite der Anordnung und schließen die Blätter 31 und 34 mit hoher Impedanz bezogen auf dieselben Punkte in der Art einer statischen Abschirmung im Innern der Anordnung ein, mit der Wirkung, daß das entstehende Gebilde seine Resonanzfrequenz bei kapazitiven Näherungen nur wenig ändert. Die Abzweigungen 51 und 52 sind nicht Bestandteil der eigentlichen Spule, sondern Abschirmflächen niedriger Impedanz, die die Leitungsstücke 53 und 54 mit höherer Impedanz nach außen abschirmen.

d) Die außen liegenden Windungen mit größter Leiterbreite, d.h. geringstem Bahnwiderstand, sind die, in denen die größte Stromstärke auftritt. Der Aufbau der Anordnung kommt also auch einer größtmöglichen Kreisgüte entgegen.

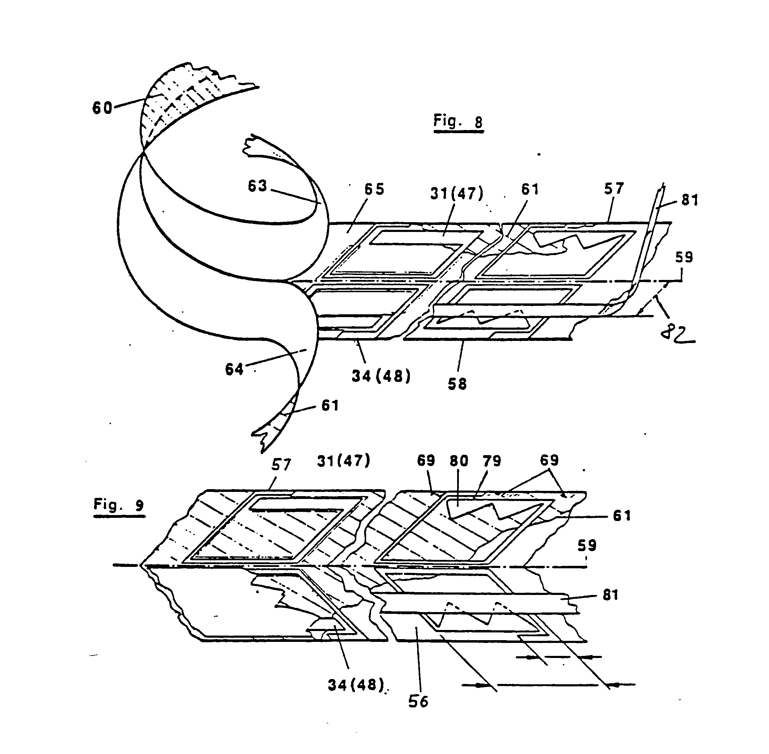

Eine hohe Positioniergenauigkeit der einzelnen Blätter aufeinander wird durch eine erzwungene Faltung gesichert. Diese wird dadurch erreicht, daß das Leiterbahngebilde gemäß Fig. 1 beim Herstellungsprozeß auf einer endlosen Trägerfolie 56 fixiert wird und bei diesem Vorgang im gleichen Werkzeug ohne Maßversatz zum fixierten Gebilde dieses zusammen mit der Trägerfolie 56 fortlaufend längs den Linien 43, 44 bzw. der Achse 36 in Fig. 1 perforiert oder feingelocht wird, so daß gemäß Fig. 7 Perforationslinien 57, 58 und 59 längs der Laufrichtung der Folie 56 entstehen, entlang denen die endlose Bahn zusammengefaltet werden kann.

Diese Perforation wird dabei so ausgeführt,

—daß eine elektrisch leitende Verbindung durch den Perforationsbereich des Gebildes erhalten bleibt,

—daß die Längssteifigkeit des Unterlagenmaterials zur Unterstützung einer geführten Faltung ausgenutzt werden kann und

—daß nicht mehr benötigte Teile der Transportbahn nach einmalig erfolgter Umklappung entlang dieser Perforation abgetrennt werden können.

Wird zur Herstellung des Gebildes gemäß Fig. 1 als Ausgangsmaterial eine beidseitig dielektrisch beschichtete Metallfolie benutzt, so entfällt das Einfügen der durchgehenden Isolierbeläge 40, 41 und 42 beim Zusammenfalten. Da die wirksamen dielektrischen Schichten gemäß Fig. 5 dann dieselben Konturen aufweisen wie die Leiterbahnen, sind die Innen- und Außenräume der fertig zusammengefalteten Anordnung dann frei von jeglichem Material, so daß das zusammengefaltete Gebilde für sich allein nch keine stabile Form hat.

Das Herstellen und formstabilisierende Einarbeiten des Bauteils zwischen schützende Deckflächen kann gemäß Fig. 7, Fig. 8 und Fig. 9 dadurch erfolgen, daß als endlose Trägerfolie 56 ein zu diesem Zweck geeignetes, z.B. mit Beschriftungsfeldern 60 versehenes Material benutzt wird, das auf der freien Seite mit einer Haft- oder Siegelschicht 61 ausgerüstet ist, die unterschiedliche Haftung auf den Zonen innerhalb und außerhalb der Perforationslinien 57 und 58 erzeugt und selektiv z.B. durch Druck- und/oder Wärmeeinwirkung aktiviert werden kann. Nach dem Übertragen des aus den Blättern 31 bis 34 bestehenden Gebildes auf eine solche Trägerfolie 56 wird durch die zonenweise unterschiedliche Haftung erreicht, daß die Blätter 32 und 33 auf der Folie 56 zunächst besser haften als die Blätter 31 und 34.

Mit einem geeigneten Verfahren wird dann auf die Oberfläche des Leiterbahngebildes, nicht jedoch auf die Folie, wie in Fig. 7 angedeutet, eine äußerst dünne Haftschicht 62 angebracht, die nach dem Umfalten längs der Perforationslinien 57 und 58 zwischen den Blättern 31 und 32 bzw 34 und 33 ein höheres Haftvermögen erzeugt, als es zwischen den Blättern 32 und 33 und der Folie 56 zunächst besteht.

Dies erlaubt nach Ausführung des ersten Faltvorganges längs der Perforationslinien 57 und 58, der die Blätter 31 und 32 bzw. 34 und 33 haftend aufeinander positioniert, gemäß Fig. 8 das Wiederabheben und Abtrennen nicht mehr benötigter Teile 63 und 64 der Trägerfolie 56 längs den Perforationslinien 57 und 58, ohne daß das Leiterbahngebilde vom Rest 65 der Trägerfolie wieder abgehoben wird. Der zweite Faltvorang längs der Perforationslinie 59 positioniert dann die Blätter 31 und 34 aufeinander, wie dies in Fig. 9 veranschaulicht ist.

Wird nach dem letzten Faltvorgang, der das Gebilde zu einem Resonanzkreis schließt, die Haft- oder Siegelschicht 61 im Innern des Restes 65 der als äußere Umhüllung verbliebenen Trägerfolie 56 in geeigneter Weise z.B. durch Druck- und/oder Wärmeeinwirkung aktiviert, so leistet das beschriebene Strukturmerkmal außerdem, daß das zusammengefaltete Gebilde zwischen den einhüllenden Belägen nicht nur vom durchbrochenen Innenraum her, sondern auch an den außen liegenden Perforationsrändern an Stellen 69 umschliessend eingesiegelt wird. Dadurch wird eine hohe Verschiebestabilität der Anordnung erreicht, so daß das so entstandene Band zu einer Vorratsrolle aufgerollt werden kann.

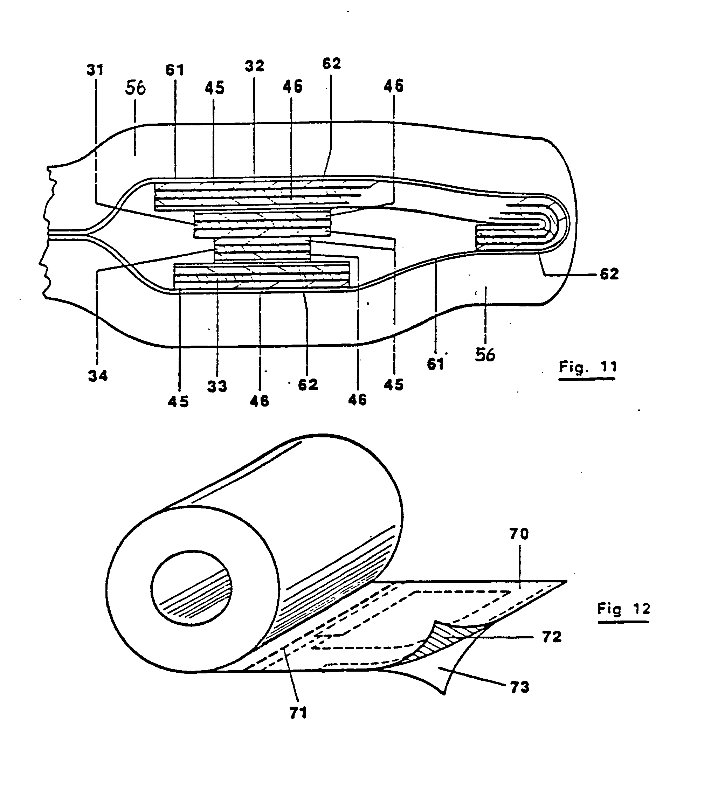

Fig. 11 zeigt zur Verdeutlichung einen Querschnitt durch den äußeren Bereich einer auf diese Weise hergestellten Anordnung.

Gemäß Fig. 12 können nach diesem Verfahren viele dünne und flexible Resonanzelemente 70 hergestellt werden, die in eine endlose Hülle eingebracht sind. Von diesem Endlosband können sie entweder einzeln abgeschnitten oder nach einer Abtrennperforation 71 und Ausrüstung mit einem Haftkleber 72 mit Trennfolie 73 mit automatischen Abrollspendern auf Objekte flexibel übertragen werden.

In einem fließenden Fertigungsprozeß der beschriebenen Art kann die Resonanzfrequenz der Anordnung unabhängig von auftretenden Schwankungen der Eigenschaften der Dielektrika 45 und 46 bzw. 40, 41 und 42, der Haftschicht 62 oder der Trägerfolie 56 sowie sonstiger Prozeßparameter innerhalb vorgebbarer Frequenzgrenzen gehalten werden, indem gemäß Fig. 10 Konturen 79 kapazitiv wirkender Abgleich-Leiterbahnteile 80 schräg zur Fortbewegungsrichtung der Trägerfolie vorgesehen werden und zwischen diese Leiterbahnteile 80 fortlaufend ein ausreichend breites, isolierendes Band 81 mit relativ geringer Dielektrizitätszahl und hinreichender Dicke in Richtung der Fortbewegungsrichtung der Trägerfolie 56 eingefügt wird. Dadurch kann die wirksame Kreiskapazität und somit die Resonanzfrequenz der fertigen Anordnung in Abhängigkeit vom Spurabstand 82 dieses Abgleichbandes zur Perforationslinie 59 beeinflußt werden.

Ein geeigneter geschlossener Regelkreis, der die Ist-Frequenz gefertigter Anordnungen berührungslos erfaßt, mit einer vorgegebenen Soll-Frequenz kontinuierlich vergleicht und in seiner Dynamik auf die Zahl gefertigter Anordnungen pro Zeiteinheit abstimmbar ist, kann so über ein Regelung des Spurabstandes 82 diese Abgleichbandes die Einhaltung vorgebbarer Schranken der Resonanzfrequenz automatisch steuern.

Das Einfügen eines solchen Abgleichbandes 81 kann je nach der gewünschten Abgleichsteilheit entweder gemäß Fig. 10 durch Aufwalzen nach dem Auftrag der Haftschicht 62 auf das noch ungefaltete Gebilde unter Ausnutzung der Haftung eben dieser Schicht 62 oder aber, wie in Fig. 8 und Fig. 9 angedeutet, in gleicher Weise nach der ersten Umfaltung unter Ausnutzung selektiver Hafteigenschaften der Trägerfolie 56 erfolgen.

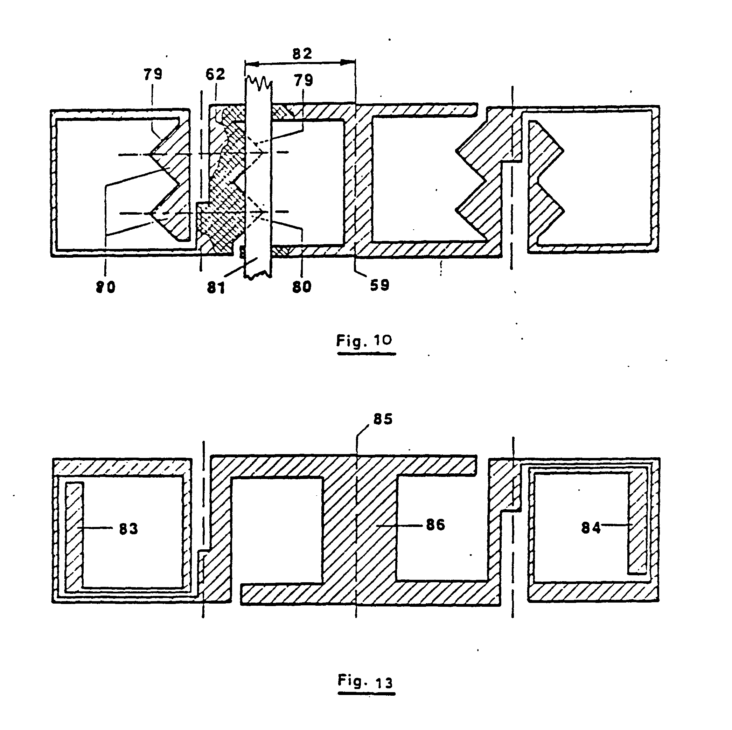

Eine Erhöhung der Induktivität bei verbesserter Abschirmung kann unter Beibehaltung des vierblättrigen Prinzips gemäß Fig. 13 durch Erhöhung der Windungszahl der nach dem Zusammenfalten innenliegenden Blätter erreicht werden. Dabei können die als Kondensatorbeläge wirkenden Leiterbahnteile 83 und 84 so angeordnet werden, daß sie unter die beiden außenliegenden Hälften der zuletzt entlang der Linie 85 gefalteten, mittleren Leiterbahn 86 des Gebildes zu liegen kommen, die die niedrigste Ankoppelimpedanz hat. Die Unabhängikeit der Resonanzfrequenz von kapazitiven Näberungseinflüssen wird dadurch weiter verbessert.

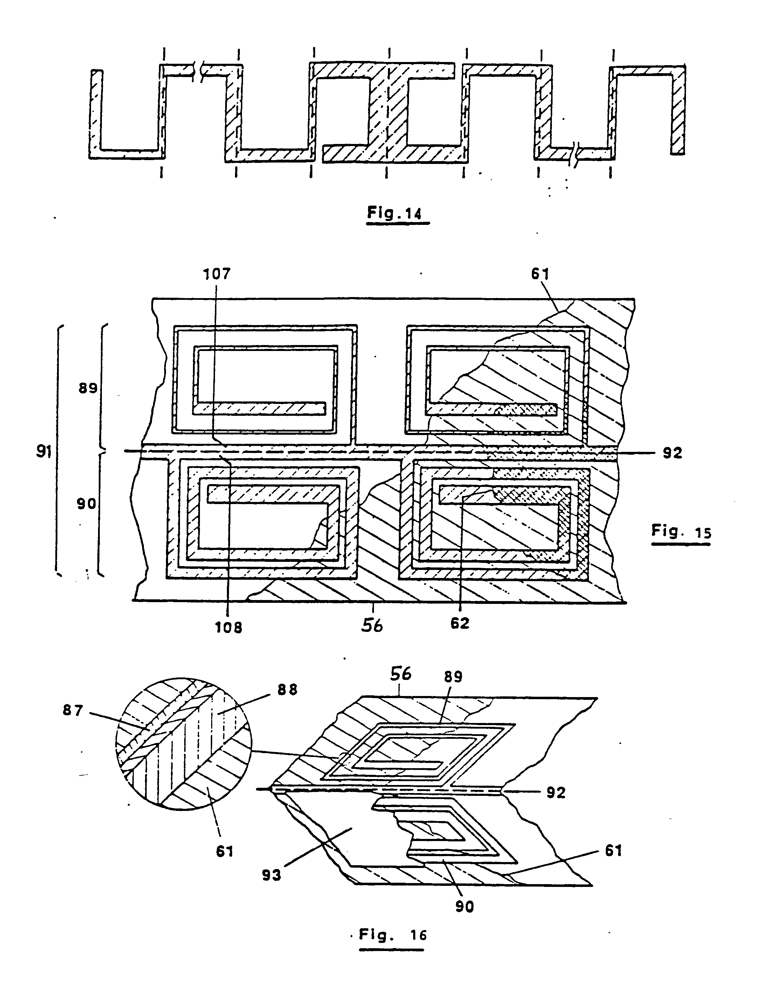

Die gleiche Wirkung wird erzielt, wenn die Struktur mit mehr als vier Lagen ausgeführt wird. Die mögliche Form einer vielblättrigen Struktur, die auch unsymmetrisch nach beiden Seiten mäanderförmig fortgesetzt werden kann, ist in Fig. 14 skizziert. Die erforderliche Abstufung der Leiterbahnbreiten ist hier nur angedeutet.

Schnell und besonders einfach können zweilagige Anordnungen mit erhöhter windungszahl hergestellt werden, indem aus einer dünnen Metallfolie 87, die mit einem geeigneten dielektrischen Belag 88 versehen ist, gemäß Fig. 15 ein aus zwei Teilblättern 89 und 90 bestehendes, ebenes Leiterbahngebilde 91 hergestellt und auf einer haftend oder siegelbar ausgebildeten Trägerfolie 65a fixiert wird, und dieses dann gemäß Fig. 16 zusammen mit dem darauf befindlichen Leiterbahngebilde entlang einer ohne Maßversatz hergestellten, das Leiterbahngebilde und die Trägerfolie fortlaufend durchdringenden Perforationslinie 92 so zusammengefaltet wird, daß die dielektrischen Beläge zwischen den Leiterbahnen des zusammengefalteten Gebildes eingeschlossen werden. Auch hier findet das Prinzip der elektrischen Leitung durch eine Perforationszone längs einer Faltlinie Anwendung. Wird als Ausgangsmaterial eine Metallfolie 87 ohne dielektrischen Belag 88 benutzt, muß gemäß Fig. 16 ein Dielektrikum 93 zwischen die beiden Teilblätter eingelegt werden. Auch in diesem Fall entsteht ein Thomsonscher Schwingungskreis mit verteilten Kapazitäten.

Versuchsmuster zeigten, daß ein Fixieren der dielektrischen Beläge 88 aufeinander oder der Leiterbahnen 87 auf einem einzulegenden Dielektrikum 93 durch eine besonders Haftschicht 62 entfallen kann, wenn das Gebilde vermittels einer geeigneten Siegelschicht 61 rundum im Hüllmaterial 65 eingeschlossen wird.

Auch bei dieser Ausführungsform werden Kondensatorflächen am besten so angelegt, daß sie langgestreckt in Windungsrichtung orientiert sind, da sie so gleichzeitig als Bestandteil der Spulenwicklung eine größtmögliche Induktionsfläche bei kleinstmöglicher Feldverzerrung ermöglichen.

Bei ausreichender Größe der überlagerten Leiterbahnen können besondere Kondensatorflächen entfallen, so daß die Windungen im Innern der Blattstrukturen dann ohne Abschluß offen enden.

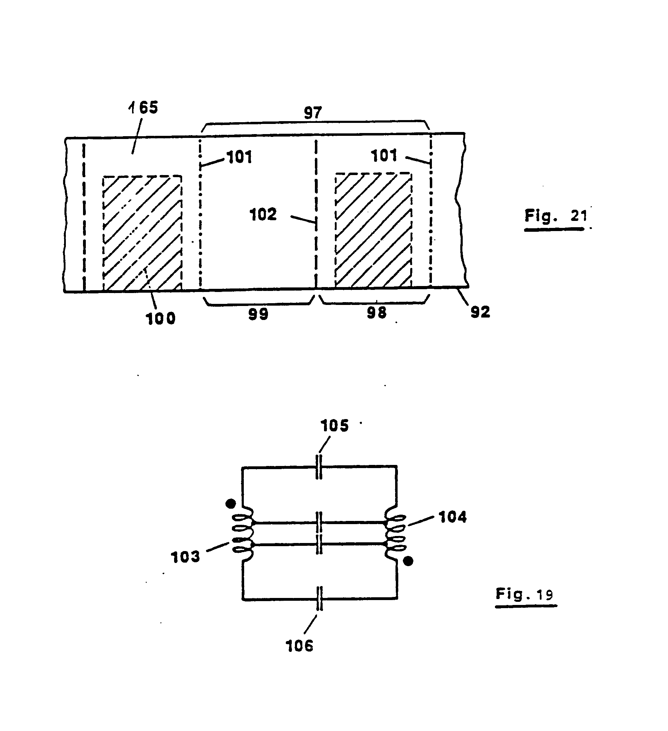

Wird das Prinzip der elektrischen Leitung durch eine perforierte Zone längs einer Faltlinie aufgegeben und bei der Ausführungsform gemäß Fig. 16 die elektrisch leitende Verbindung längs der Perforationslinie 92 aufgetrennt, so entsteht gemäß Fig. 19 ein Parallelrezonanzkreis mit seriengeteilter Induktivität 103 und 104 und seriengeteilter Kapazität 105 und 106, indem der Kapazitätsbelag zwischen den dann voneinander isolierten Leiterbahnhälften 107 und 108 entlang der Perforationslinie 92 als Serienkondensator 106 wirksam wird. In Fig. 19 sind auch die verteilten Kapazitäten der Windungsflächen gegeneinander angedeutet.

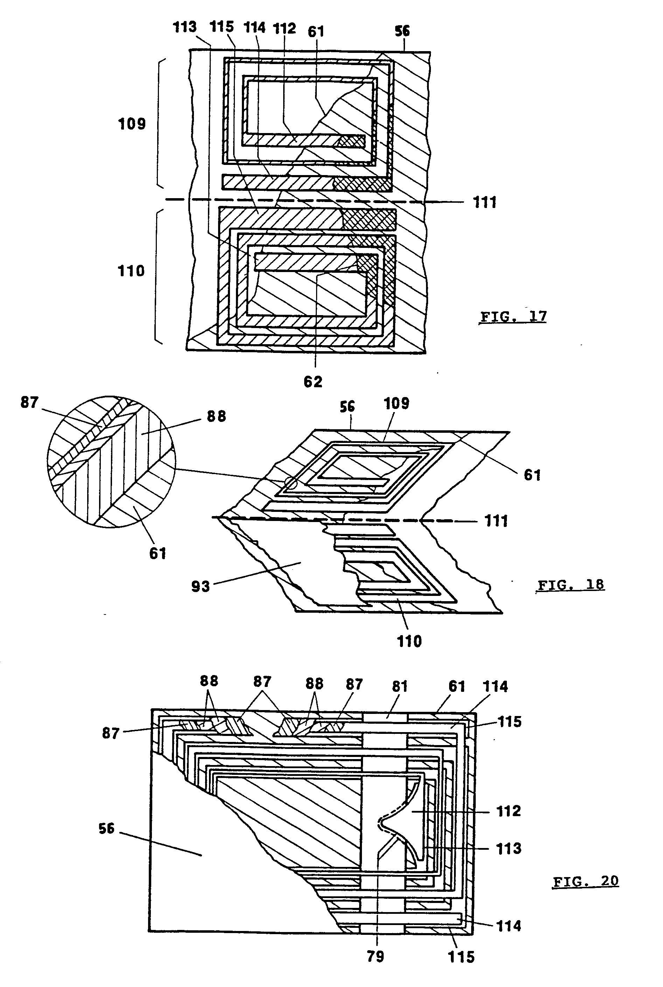

Eine solche Ausführungsform läßt sich wiederum unter Anwendung des Prinzips ungleicher, sich überdeckender Leiterbahnbreiten für weitgehende Frequenzinvarianz gegenüber Positionierungsungenauigkeiten sehr schnell und einfach herstellen, indem aus einer dünnen Metallfolie 87—die auch einseitig bereits mit einem geeigneten dielektrischen Belag 88 versehen sein kann—zwei voneinander getrennte, ebene Gebilde 109 und 110 gemäß Fig. 17 hergestellt und auf einer haftend oder siegelbar ausgebildeten Trägerfolie 65 fixiert werden, wobei diese im gleichen Arbeitsgang ohne Maßversatz zwischen den Strukturen fortlaufend perforiert wird, so daß sie gemäß Fig. 18 zusammen mit den darauf befindlichen Leiterbahngebilden 109 und 110—erforderlichenfalls unter Einlage eines Dielektrikums 93—entlang der entstehenden Perforationslinie 111 so zusammengefaltet werden kann, daß die beiden Leiterbahngebilde 109 und 110 sich überdecken und über ihre leiterbahnteile 112/113 sowie 114/115 miteinander keine elektrische, sondern nur eine kapazitive Kopplung durch die trennende Isolierschicht 88 oder 93 hindurch haben und das so entstehende Resonanzelement allseitig in der Trägerfolie 56 in der Art einer Schutzhülle eingesiegelt wird. Zur Beeinflussung der Resonanzfrequenz ist wiederum ein Abgleichband 81 vorgesehen (Fig. 20), das mit Abgleichflächen 112 zusammenwirkt, wie im einzelnen anhand der Fig. 10 erläutert wurde. Die Abgleichflächen 112 sind so konstruiert, daß sich eine angenähert quadratische Abhängigkeit der Abgleichkapazität von der Parallelverschiebung des Abgleichbandes 81 bzw. lineare Abhängigkeit der Resonanzfrequenz von dieser Parallelverschiebung ergibt.

Da die beschriebene Identifizierungsanordnung nicht nur besonders schnell und einfach, sondern ach mit geringstmöglichem Abfall an Rohmaterial hergestellt werden kann, kommt sie ganz besonders zur Ausrüstung von Warenauszeichnungs- und Sicherungsetiketten in Betracht.

Gemäß Fig. 21 kann zu diesem Zweck z.B. ein datentragendes Auszeichnungsdoppeletikett 97—bestehend aus einem mit einer derartigen Identifizierungsanordnung bestückten Kassenabschnitt 98 und einem damit unausgerüsteten Kundenabschnitt 99—hergestellt werden, indem als Fertigungsträger 165 entsprechend vorbedrucktes, als Datenträger geeignetes Hüllmaterial benutzt wird und ausreichende Abstände zwischen den auf diesen Träger fixierten Strukturen belassen werden, so daß nach dem Zusammenfalten entlang der Perforationslinie 92 und Versiegeln der Trägers jeweils ein mit einem Resonanzelement 100 bestücktes und ein damit unbestücktes Feld abwechselnd aufeinanderfolgen. Dieses Band wird anschießend mit in festem Abstand auf die eingearbeiteten Resonanzelemente folgenden Querperforationen 101 zum Abtrennen einzelner Etiketten und einer jeweils zwischengeschalteten Querperforation 102 zum Auseinandertrennen von Kunden- und Kassenabschnitt versehen.

Werden Waren- und Preisdaten von derartigen Etiketten nicht manuell, sondern mittels einer eigens dafür vorgesehenen Einrichtung selbsttätig in die Kasse eingegeben, so kann die Einarbeitung eines solchen Resonanzelements auch in den Kundenanschnitt erfolgen, wenn der Kundenabschnitt unmittelbar nach der Registrierung noch im Einlesegerät an geeigneter Stelle durchstanzt und das Resonanzelement im Innern dadurch unwirksam gemacht wird.

Da diese Anordnung keine Abschirmung nach außen aufweist und Warensicherungsetiketten kleinstmöglich ausgeführt sein sollen, können bei großflächiger Abdeckung mit Gegenständen oder Körperteilen Änderungen der Kreiskapazität und damit der Resonanzfrequenz auftreten.

Um diesen Effekt geringstmöglich zu halten, werden gemäß bevorzugten Ausführungsformen folgende Maßnahmen getroffen:

—Das Deckermaterial wird ausreichend dick gewählt, und der wesentliche Teil der Schwingkreiskapazität befindet sich an der Peripherie der Anordnung, d.h. im Kapazitätsbelag zwischen den ersten Windungen beginnen und an der Perforationslinie konzentriert;

—die Enden der Spule sind nur mit relativ kleinflächigen Kondensatorbelägen abgeschlossen;

—die Dielektrizitätszahl des Dielektrikums wird möglichst groß und die Dielektrizitätszahl des Hüllmaterials wird möglichst klein gewählt.

Als Bestandteil elektronischer System zur Entdeckung von Warendiebstählen oder zur Überwachung der Zutriffsbefugnis von Personen sind bereits herkömmliche Anordnungen im Gebrauch, die in einem festen, meist zweiteilig ausgeführten Gehäuse einen Schwingungskreis enthalten, bestehend aus einer Spulenwicklung aus blankem oder isoliertem Draht und einem Kondensator herkömmlicher Bauform, der an die Enden der Spulenwicklung angeschlossen ist.

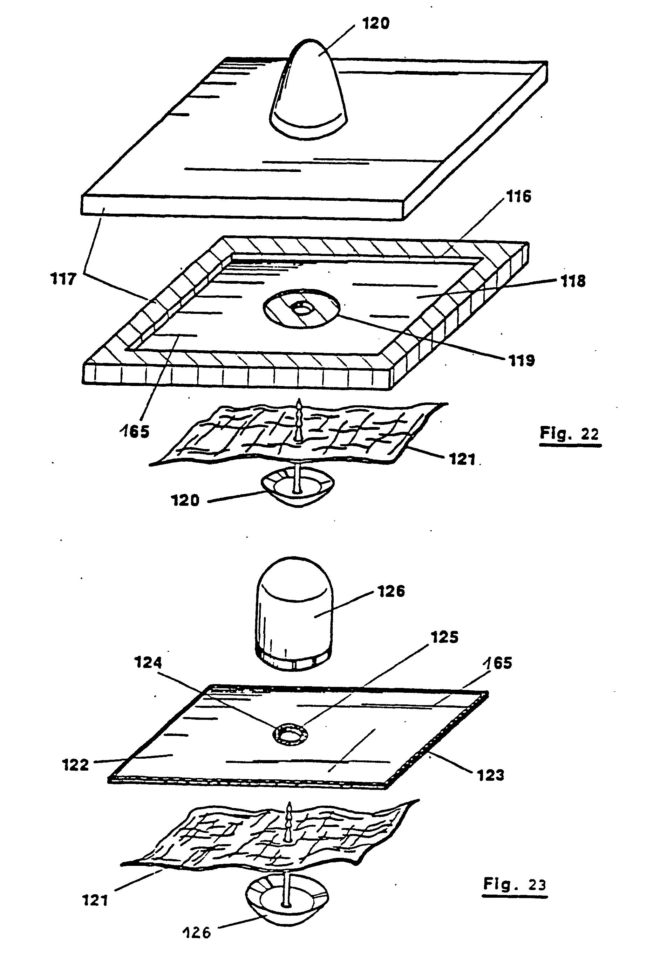

Das Einbringen dieser Teile in bisher üblicher Art kann entfallen, indem gemäß Fig. 22 in eine passende, flächenhafte Aussparung 116 im Inneren eines ähnlich gestalteten Gehäuses 117 eine der beschriebenen Resonanzanordnungen 118 eingelegt wird, wobei die papier- oder pappartige Trägerhülse 165 einer solchen Anordnung innerhalb des eingeschlossenen Resonanzgebildes mit einer Lochung 119 versehen sein kann, um einen das gesamte Gehäuse durchdringenden Schließmechanismus 120 aufzunehmen, wie er für wieder lösbare Befestigung des Gesamtgebildes an Kleidungsstücken 121 erforderlich sein kann.

Wenn ein solcher Schließmechanismus nicht untrennbar fest mit einer Identifikationsanordnung verbunden sein muß, und die Identifikationsanordnung selbst als flexibles, widerstandsfähiges, mehrfach anwendbares Etikett 122 ausgeführt sein soll, so kann ein solches gemäß Fig. 23 dadurch hergestellt werden, daß als Fertigungsträger 165—und damit als Hüllmaterial des Resonanzelements—ein ausreichend dickes, reißfestes Material mit knickwiderstandsfähiger Armierung benutzt wird, das an der Berandung der Anordnung erforderlichenfalls durch eine Schweißnaht 123 einreißfest versiegelt werden kann.

Eine ebenfalls durch Umschweißung 124 randverstärkte Bohrung 125 im inneren Teil eines solchen Etiketts kann eine lösbare Befestigung an Handelsware 121 mit üblichen, hierzu geeigneten Vorrichtungen 126 ermöglichen.

**Patentansprüche**

1. Identifizierungsanordnung in Form eines an einem Gegenstand anbringbaren Etiketts, welches wenigstens ein aus flächenhaften Leiterbahnen (47 bis 54 83, 84, 86; 87 von 89 und 90; 87 von 109 und 110) gebildetes induktives Element (103, 104) und ein aus übereinander angeordneten Leiterbahnen (47 bis 54, 83, 84, 86; 87 von 89 und 90; 87 von 109 und 110) und einem dazwischengefügten Dielektrikum gebildetes kapazitives Element (105, 106) enthält, das mit dem induktiven Element (103, 104) einen Resonanzkreis bildet, dadurch gekennzeichnet, daß die Leiterbahnen (47 bis 54, 83, 84, 86; 87 von 89 und 90; 87 von 109 und 110) als Streifenleitung (37, 38, 39) ausgebildet sind, bei der die das kapazitive Element (105, 106) bildenden Leiterbahnen (37, 39; 47 bis 54, 83, 84, 86; 87 von 89 und 90; 87 von 109 und 110) mindestens teilweise mit Leiterbahnen (37, 39; 47 bis 54, 83, 84, 86; 87 von 89 und 90; 87 von 109 und 110) identisch sind, welche das induktive Element (103, 104) bilden.

2. Anordnung nach Anspruch 1, dadurch gekennzeichnet, daß die Leiterbahnen (47 bis 54,

83, 84, 86; 87 von 89 und 90, 87 von 109 und 110) derart angeordnet sind, daß bei Auseinanderfalten übereinander angeordneter Leiterbahnteile (47, 53; 49, 51; 48, 54; 50, 52; 53, 54; 87 von 89, 87 von 90; 87 von 109, 87 von 110) in eine gemeinsame Ebene die Leiterbahnteile (47, 48; 49, 50; 51, 52; 53, 54; 87 von 89, 87 von 90; 87 von 109, 87 von 110) im wesentlichen zu einem Punkt (35) zentralsymmetrisch angeordnet sind, der auf einer Achse (36; 92, 111) liegt, um die herum die Leiterbahnteile (47, 48; 49, 50; 51, 52; 53, 54; 87 von 89, 87 von 90; 87 von 109, 87 von 110) gefaltet wurden.

3. Anordnung nach Anspruch 1 oder 2, dadurch gekennzeichnet, daß Leiterbahnen (47 bis 54, 83, 84, 86) miteinander zusammenhängende Strukturen (31, 32, 33, 34) bilden und darin so angeordnet sind, daß bei Abwicklung der zusammenhängenden Strukturen in eine Ebene jedenfalls beidseitig an Nachbarstrukturen (31, 33; 32, 34) angrenzende Strukturen (32, 33) im wesentlichen einen mäanderförmigen Leiterbahnzug (49, 86, 50) bilden.

4. Anordnung nach Anspruch 3, dadurch gekennzeichnet, daß in einseitig an Nachbarstrukturen (32, 33) angrenzenden Endstrukturen (31, 34) Leiterbahnen (47, 53, 83; 48, 54, 84) gleichsinnig umlaufende Spiralbahnen mit wenigstens einer Windung bilden.

5. Anordnung nach einem der Ansprüche 1 bis 4, dadurch gekennzeichnet, daß die Leiterbahnen (47 bis 54, 83, 84, 86; 87 von 89 und 90; 87 von 109 und 110) in den einander überlagerten Flächen jeweils voneinander verschiedene Form und/oder Abmessungen haben, insbesondere unterschiedliche Breiten aufweisen.

6. Anordnung nach Anspruch 5, dadurch gekennzeichnet, daß die Leiterbahnen (Teilstrukturen 31 bis 32) in mindestens drei einander überlagerten Flächen angeordnet sind und daß die größere Abmessungen aufweisenden Leiterbahnen in den beiden äußeren Flächen und die kleinere Abmessungen aufweisenden Leiterbahnen derart zwischen den äußeren Flächen und die kleinere Abmessungen aufweisenden Leiterbahnen derart zwischen den äußeren Flächen angeordnet sind, daß sie durch die Leiterbahnen in den äußeren Flächen elektrisch nach außen abgeschirmt sind.

7. Anordnung nach einem der Ansprüche 1 bis 6, dadurch gekennzechnet, daß die Leiterbahnteile (Teilstrukturen 32, 33) mit niedriger elektrischer Impedanz auf der Außenseite von Leiterbahnteilen (Teilstrukturen 31, 34) mit hoher elektrischer Impedanz angeordnet sind.

8. Anordnung nach Anspruch 1, dadurch gekennzeichnet, daß Leiterbahnen (87) in zwei flächigen Leiterbahnstrukturen (89, 90; 109, 110) angeordnet sind und daß diese Leiterbahnstrukturen die Gestalt von Spiralpfaden (89, 90; 109, 110) mit je einer Mehrzahl von sich gegenseitig überdeckenden Windungen aufweisen, die einseitig gesehen im Gegennsin umlaufen.

9. Anordnung nach Anspruch 8, dadurch gekennzeichnet, daß das Dielektrikum wenigstens die Gestalt eines eine Leiterbahnstruktur (87, 109) überdeckenden Spiralpfades (88 von 109) aufweist, welcher mit dem Umlaufsinn der überdeckten Leiterbahnstruktur umläuft.

10. Anordnung nach Anspruch 8, dadurch gekennzeichnet, daß das Dielektrikum (88) wenigstens die Umrißfläche zweier einander deckend überlagerter Spiralpfade (89, 90; 109, 110) ausfüllt, welche zwischen Leiterbahnen (87 von 89, 87 von 90; 87 von 109, 87 von 110) einseitig gesehen im Gegensinn umlaufen.

11. Anordnung nach Anspruch 8, dadurch gekennzeichnet, daß das sich zwischen einander überlagerten Leiterbahnen (87 von 89, 90; 87 von 109, 110) vorhandene Dielektrikum (88; 93; 81) eine größere durchschnittliche Fülldichte oder Gesamtdicke aufweist als das außerhalb Überlagerungsbereichen in Zwischenwindungsräumen benachbarter Streifenleitungen vorhandene Dielektrikum (93; 81).

12. Anordnung nach einem der vorhergehenden Ansprüche, dadurch gekennzeichnet, daß zwischen jeweils zwei einander überlagerten Leiterbahnteilen (80; 112, 113) ein dielektrisches Abgleichelement (81) eingefügt ist, dessen Lage in Bezug auf diese Leiterbahnteile (80; 112, 113) einstellbar ist, wobei vorzugsweise das dielektrische Abgleichelement (81) mit durch Leiterbahnteile (80; 112, 113) gebildeten kapazitiven Abgleichflächen zusammenwirkt, deren Form in Bezug auf die Einstellrichtung des dielektrischen Abgleichelementes (81) so gewählt ist, daß durch Verlagerung desselben in Einstellrichtung zwischen zwei einander überlagerten Abgleichflächen die von diesen und von dem dielektrischen Abgleichelement (81) gebildete Abgleichkapazität sich nach einer vorgegebenen Funktion in Abhängigkeit von der Verlagerungsamplitude ändert.

13. Anordnung nach einem der Ansprüche 1 bis 12, dadurch gekennzeichnet, daß zwischen überlagerten Leiterbahnstrukturen (31, 32, 33, 34; 89, 90; 109, 110) ein wenigstens eine Teilschicht bildendes dielektrisches Material (40, 41, 42; 81, 93) sich auch im von Leiterbahnen nicht belegten inneren Bereich der Anordnung erstreckt.

14. Anordnung nach einem der vorhergehenden Ansprüche, dadurch gekennzeichnet, daß wenigstens zwei einander überlagerte Endstücke (47, 48; 83, 84; 89, 90; 109; 110) von wenigstens eine Spiralwinding bildenden Leiterbahnstrukturen (31, 34; 89, 90; 109, 110) flächenhafter als übrige Leiterbahnteile diese Leiterbahnstrukturen ausgebildet sind.

15. Anordnung nach Anspruch 8, dadurch gekennzeichnet, daß gegensinnig umlaufende Spiralwindungen (87 von 89 und 90) im Innern der Leiterbahnstrukturen ohne Abschluß durch besondere Kondensatorflächen offen enden.

16. Anordnung nach Anspruch 8, dadurch gekennzeichnet, daß die flächigen Leiterbahnstrukturen (89, 90) miteinander leitend verbunden sind, so daß die spiralförmigen Leiterbahnen (87 von 89 und 87 von 90) im wesentlichen mit konstantem Wicklungssinn in Reihe geschaltet umlaufen.

17. Anordnung nach einem der Ansprüche 1 bis 16, dadurch gekennzeichnet, daß die Leiterbahnen (47 bis 54, 83, 84, 86; 87 von 89, 90; 87 von 109, 110) auf einer flexiblen, elektrisch isolierenden Trägerfolie (56), insbesondere aus einem dielektrischen Material, aufgebracht sind, wobei die Trägerfolie (56) und/oder Leiterbahnen (107, 108) mit Faltlinuen (36, 43, 44, 92) markierenden Perforierungen (57 bis 59, 71, 92, 102, 111) und/oder Sollknicklinien ausgebildet ist.

18. Anordnung nach einem der Ansprüche 1 bis 17, dadurch gekennzeichnet, daß die Leiterbahnen (47 bis 54, 83, 84, 86; 87 von 89, 90; 87 von 109, 110) in einer papier- oder pappartigen Trägerhülle (165) eingeschlossen sind.

19. Anordnung nach Anspruch 17 oder 18, dadurch gekennzeichnet, daß die Anordnung (118, 122) eine Lochung (119, 125) in ihrem von Leiterbahnen (47 bis 54, 83, 84, 86; 87 von 89, 90; 87 von 109, 110) frei belassenen Innenbereich aufweist.

20. Verfahren zur Herstellung von einer Identizierungsanordnung in Form eines an einem Gegenstand anbringbaren Etiketts, welches wenigstens ein aus flächenhaften Leiterbahnen gebildetes induktives Element und ein aus übereinander angeordneten Leiterbahnteilen und einem dazwischengefügten Dielektrikum kapazitives Element enthält, das mit dem induktiven Element einen Resonanzkreis bildet, dadurch gekennzeichnet, daß ein in eine Ebene abwickelbares Leiterbahngebilde (30, 89, 90, 91, 109, 110) längs wenigstens einer Faltlinie (36, 43, 44, 92, 111) so zusammengefaltet wird, daß zwischen wenigstens zwei aufeinandergefalteten Leiterbahnteilen (47 bis 54, 83, 84, 86, 87 von 89 und 90, 87 von 109 und 110) ein Dielektrikum (38, 40 bis 42, 45, 46, 88, 93) eingefügt wird.

21. Verfahren nach Anspruch 20, dadurch gekennzeichnet, daß die Leiterbahnen (47 bis 54, 83, 84, 86; 89, 90; 109, 110) wenigstens teilweise mit einem Haftkleber (62) beschichtet werden und daß der Haftkleber (62) durch Druck- und/oder Wärmeeinwirkung selektiv aktiviert wird.

22. Verfahren nach einem der Ansprüche 20 oder 21, dadurch gekennzeichnet, daß eine Vielzahl von Identifizierungsanordnungen auf einer streifenförmigen, flexiblen Trägerfolie (56, 65a) aufeinanderfolgend angeordnet wird.

23. Verfahren nach einem der Ansprüche 20 bis 22, dadurch gekennzeichnet, daß Leiterbahnstrukturen (31, 32, 33, 34; 47 bis 54; 83, 84, 86; 89, 90; 109, 110) mit sich überdeckenden leitenden und dielektrischen Bahnen aus einer mit einem Dielektrikum (38; 45, 46; 88) beschichteten Metallfolie (87) hergestellt, insbesondere ausgeschinitten oder ausgestanzt, werden.

24. Verfahren nach einem der Ansprüche 20 bis 23, dadurch gekennzeichnet, daß eine Vielzahl von Identifizierunganordnungen (70) in endloser Aufeinanderfolge mit einem selbsthaftenden Film (72) und Auflösungsperforationen (71) ausgerüstet und auf einer streifenförmigen, flexiblen Trägerfolie (73) angeordnet werden, und daß die Trägerfolie (73) mit den darauf angeordneten Identizierunganordnungen (70) zu einer Vorratsrolle aufgewunden wird.

25. Verwendung der Identifizierungsanordnung nach einem der Ansprüche 1 bis 19, dadurch gekennzeichnet, daß die Identifizierungsanordnung (70; 100; 118, 122) als Bestandteil eines elektronischen Systems zur Entdeckung von Warendiebstählen oder zur Überwachung der Zutrittsbefugnis von Personen betrieben wird.

26. Verwendung nach Anspruch 25, dadurch gekennzeichnet, daß die Identifizierungsanordnung (70; 100; 118; 122) an/in Objekten (117, 121) oder an/in einem vorbedruckten, mit einem zum Tragen von Daten geeigneten Hüllmaterial ausgestatteten Warenauszeichnungsetikett (97) angeordnet ist.

27. Verwendung nach Anspruch 26, dadurch gekennzeichnet, daß das Warenauszeichnungsetikett (97) einen Kundenabschnitt (99) und einen mit diesem lösbar verbundenen Kassenabschnitt (98) aufweist und die Identifizierungsanordnung (100) wenigstens in einem der beiden Abschnitte (98, 99) angeordnet ist.

28. Verwendung nach einem der Ansprüche 25 bis 27, dadurch gekennzeichnet, daß die Identifizierungsanordnung an geeigneter Stelle durchstanzt und dadurch unwirksam gemacht wird.

**Revendications**

1. Dispositif d'identification en forme d'une etiquette, qui peut être sur un objet comprenant au moins un élément inductif (103, 104) composé de pistes conductives planes (47 à 54, 83, 84, 86; 87 de 89 et 90; 87 de 109 et 110), et un élément capacitif (105, 106) constitué par des pistes conductives superposées (47 à 54, 83, 84, 86; 87 de 99 et 90; 87 de 109 et 110) et par un diélectrique intercalé; cet élément capacitif (105, 106) constitue un circuit de résonance avec l'élément inductif (103, 104), caractérisé en ce que les pistes conductives (47 à 54, 83, 84, 86; 87 de 89 et 90; 87 de 109 et 110) ont la forme d'un guide d'ondes à rubans (37, 38, 39) dans lequel les pistes conductives (37, 39; 47 à 54, 83, 84, 86; 87 de 89 et 90; 87 de 109 et 110) constituant l'élément capacitif (105, 106) sont au moins partiellement identiques aux pistes conductives (37, 39; 47 à 54, 83, 84, 86; 87 de 89 et 90; 87 de 109 et 110), qui constituent l'élément inductif.

2. Dispositif suivant la revendication 1, caractérisé par le fait que les pistes conductives (47 à 54, 83, 84, 86; 87 de 89 et 90, 87 de 109 et 110) sont disposées de manière telle que lors du dépliage des tronçons de pistes conductives superposées (47, 53; 49, 51; 48, 54; 50, 52; 53, 54; 87 de 89, 87 de 90; 87 de 109, 87 de 110) un un plan commun, les tronçons de pistes conductives (47, 48; 49, 50; 51, 52; 53, 54; 87 de 89, 87 de 90; 87 de 109, 87 de 110) sont orientés en substance en symétrie centrale vers un point (35), lequel est situé sur un axe (36; 62, 111), autour duquel avaient été pliés les tronçons de pistes conductives (47, 48; 49, 50; 51, 52; 53, 54; 87 de 89, 87 de 90; 87 de 109, 87 de 110).

3. Dispositif suivant la revendication 1 ou 2, caractérisé par le fait que les pistes conductives (47 à 54, 83, 84, 86) constituent des structures, les unes cohérents avec les autres (32, 32, 33, 34) et y sont disposées de manière telle qu'en tout cas lors du developpement en un plan des structures cohérentes, des structures (32, 33) bornant de part et d'autre des structures voisines (31, 33; 32, 34) forment en substance une suite de pistes conductives en forme de méandre (49, 86, 50).

4. Dispositif suivant la revendication 3, caractérisé par le fait qu'au sein des structures terminales (31, 34) bornant unilatéralement des structures voisines (32, 33) des pistes conductives (47, 53, 83; 48, 54, 84) forment des bandes en spirale constituant au moins une spire.

5. Dispositif suivant l'une des revendications 1 à 4, caractérisé par le fait que les pistes conductives (47 à 54, 83, 84, 86; 87 de 89 et 90; 87 de 109 et 110) dans les plans superposés présentent des formes et/ou des dimensions différentes l'une de l'autre, et présentent notamment des largeurs différentes.

6. Dispositif suivant la revendication 5, caractérisé en ce que les pistes conductives (structures partielles 31 à 32) sont disposées dans au moins trois plans superposés et en ce que les pistes conductives présentant des dimensions plus grandes sont disposées dans les deux plans extérieurs tandis que les pistes conductives présentant des dimensions plus petites sont disposées entre les plans extérieurs de telle manière qu'elles sont blindées électriquement vers l'extérieur par les pistes conductives situées dans les plans extérieurs.

7. Dispositif suivant l'une des revendications de 1 à 6, caractérisé en ce que les tronçons de pistes conductives (structures partielles 32, 33) à faible impédance électrique sont disposés sur la face extérieure des tronçons de pistes conductives (structures partielles 31, 34) à impédance électrique élevée.

8. Dispositif suivant la revendication 1, caractérisé en ce que des pistes conductives (87) sont disposées dans deux structures de pistes conductives (89, 90; 109, 110) planes et en ce que ces structures de pistes conductives présentent la forme de pistes à spirales (89, 90; 109, 110) présentant chacure une pluralité de spires se recouvrant mutuellement qui, observées à partir d'un même côté sont orientées en sens opposé.

9. Dispositif suivant la revendication 8, caractérisé en ce que le diélectrique présente tout au moins la forme d'une piste à spirale (88 de 109) recouvrant une structure de piste conductive (87, 109); cette piste à spirale tourne dans le même sens que la structure de piste conductive recouverte.

10. Dispositif suivant la revendication 8, caractérisé en ce que le diélectrique (88) occupe au moins l'espace délimité par le contour de deux pistes à spirales qui se recouvrent (89, 90; 109, 110); ces pistes à spirales observés à partir d'un même côté entre des pistes conductives (87 de 89, 87 de 90; 87 de 109, 87 de 110), tournent en sens contraire.

11. Dispositif suivant la revendication 8, caractérisé par le fait que le diélectrique (88; 93; 81) présent entre des pistes conductives superposées mutuellement (87 de 89, 90; 87 de 109, 110) présente une densité de remplissage moyenne ou une épaisseur totale plus grande que le diélectrique (93; 81) présent en dehors des zones des recouvrement dans les espaces intermédiaires des spires des guides d'ondes à rubans voisines.

12. Dispositif suivant l'une quelconque des revendications précédentes, caractérisé par le fait que chaque fois entre deux ségments de pistes conductives superposées (80; 112, 113) un élément d'équilibrage diélectrique (81) est intercale, dont la position est réglable par rapport à ces ségments de pistes conductives (80, 112, 113), l'élément d'équilibrage diélectrique (81) coopérant de préférence avec des surfaces d'équilibrage capacitives constituées par des ségments de pistes conductives (80; 112, 113), dont la forme est, par rapport à la direction d'équilibrage de l'élément d'équilibrage diélectrique (81) mentionné, choisie de telle manière que par le déplacement de ce dernier dans la direction de réglage entre deux surfaces d'équilibrage superposées mutuellement, la capacité d'équilibrage constituée par ces surfaces et par l'élément d'équilibrage (81) varie suivant une fonction prédéfinie selon l'amplitude de déplacement.

13. Dispositif suivant l'une des revendications 1 à 12, caractérisé par le fait qu'entre des structures de pistes conductives superposées (31, 32, 33, 34; 89, 90; 109, 110), un matériau diélectrique (40, 41, 42; 81, 93) constituant au moins une couche partielle s'étend aussi dans la région intérieure du dispositif qui n'est pas occupée par des pistes conductives.

14. Dispositif suivant l'une quelconque des revendications précédentes, caractérisé par le fait que tout au moins deux pièces terminales (47, 48; 83, 84; 89, 90; 109, 110) de structures de pistes conductives (31, 34; 89, 90; 109, 110) constituant au moins une spire sont de nature plus plate que d'autres ségments de pistes conductives de ces structures de pistes conductives.

15. Dispositif suivant la revendication 8, caractérisé par le fait que des enroulements en spirale orientés en sens contraire (87 de 89 et 90) au sein des structures de pistes conductives se terminent de manière ouverte sans être bornés par des surfaces de condensateur particulières.

16. Dispositif suivant la revendication 8, caractérisé en ce que les structures de pistes conductives planes (89, 90) sont connectées électriquement, de telle sorte que les pistes conductives spiraloides (87 de 89 et 87 de 90) sont montées en série et sont enroulées avec un sens d'enroulement en substance constant.

17. Dispositif suivant l'une quelconque des revendications de 1 à 16, caractérisée par le fait que les pistes conductives (47 à 54, 83, 84, 86; 87 de 89, 90; 87 de 109, 110) sont appliquées sur une feuille de support flexible électriquement isolante (56), notamment en un matériau diélectrique, la feuille de support (56) et/ou les pistes conductives (107, 108) présentant des perforations (57 à 59, 71, 92, 102, 111) marquant des lignes de pliage, (36, 43, 44, 92) et/ou des lignes de pliage de consigne positives.

18. Dispositif suivant l'une quelconque des revendications de 1 à 17, caractérisée par le fait que les pistes conductives (47 à 54, 83, 84, 86; 87 de 89; 87 de 109, 110) sont enrobées dans une gaine de support (165) ayant la nature du papier ou du carton.

19. Dispositif suivant la revendication 17 ou 18, caractérisée par le fait que le dispositif (118, 122) présente une trou poinçonné (119, 125) dans sa région intérieure non occupée par des pistes conductives (47 à 54, 83, 84, 86; 87 de 89, 90; 87 de 109, 110).

20. Procédé de fabrication d'un dispositif d'identification en forme d'une étiquette qui peut être fixée sur un objet comprenant au moins un élément inductif composé de pistes conductives planes et un élément capacitif constitué par des pistes conductives mutuellement superposées et par un diélectrique y intercalé, l'élément capacitif constituant un circuit de résonance avec l'élément inductif, caractérisé par le fait qu'une structure de pistes conductives (30, 89, 90, 91, 109, 110) susceptible d'être développée en un plan est, le long d'au moins une ligne de pliage (36, 43, 44, 91, 111), pliée de telle manière qu'entré au moins deux segments de pistes conductives (47 à 54, 83, 84, 86, 87 de 89 et 90, 87 de 109 et 110) pliés l'un sur l'autre est interposé un diélectrique (38, 40 à 42, 45, 46, 88, 93).

21. Procédé suivant la revendication 20, caractérisé par le fait que les pistes conductives (47 à 54, 83, 84, 86; 89, 90; 109, 110) sont revêtues au moins partiellement d'un produit adhésif (62) et en ce que les produit adhésif (62) est activé sélectivement sous l'action de la pression et/ou de la chaleur.

22. Procédé soivant la revendication 20 ou 21, caractérisé par le fait qu'une pluralité de dispositifs d'identification sont disposés en succession sur une feuille de support flexible en forme de ruban (56, 65a).

23. Dispositif suivant l'une des revendications de 20 à 22, caractérisé par le fait que des structures de pistes conductives (31, 32, 33, 34; 47 à 54; 83, 84, 86; 89, 90; 109, 110) comportant des pistes conductives et diélectriques mutuellement superposées sont fabriquées à partir d'une feuille metallique (87) revétue d'un diélectrique (38; 45, 46; 88), notamment par decoupage ou estampage.

24. Procédé soivant l'une des revendications de 20 à 23, caractérisé par le fait qu'une pluralité de dispositifs d'identification (70) en succession sans fin sont dotés d'une film auto-adhésive (72) et de perforations de separation (71) et sont disposés sur une feuille de support flexible en forme de ruban (73), et en ce que la feuille de support (73) avec les dispositifs d'identification (70) y disposés est enroule un rouleau d'approvisionnement.

25. Utilisation du dispositif d'identification selon l'une des revendications de 1 à 19, caractérisé en ce que le dispositif d'identification (70; 100; 118, 122) constitué un composant d'un système électronique pour la détection de vols de marchandises ou pour le contrôle d'admission de personnes.

26. Utilisation selon la revendication 25, caractérisée en ce que le dispositif d'identification (70; 100; 118, 122) est disposé sur/dans des objets (117, 121) ou dans/sur une étiquette d'identification de marchandise préimprimée (97) équipée d'un matériau de gainage adéquat pour porter d'informations.

27. Utilisation suivant la revendication 26, caractérisé en ce que l'étiquette d'identification de marchandise (97) comporte une section (99) destinée au client et une section de caisse (98) y reliée de manière détachable et en ce que le dispositif d'identification (100) est disposé dans au moins une des deux sections (98, 99).

28. Utilisation suivant l'une des revendications de 25 à 27, caractérisée en ce que le dispositif d'identification est perforé en un endroit approprié et est de la sorte rendu inactif.

**Claims**

1. Tag-shaped identification device affixable to an object and comprising at least an inductive element (103, 104) formed of planar conductor paths (47 to 54, 83, 84, 86; 87 of 89 and 90; 87 of 109 and 110) and a capacitive element (105, 106) formed of mutually superposed conductor paths (47 to 54, 83, 84, 86; 87 of 89 and 90; 87 of 109 and 110) and a dielectric spaced therebetween, said capacitive element and said inductive element forming a resonant circuit, characterized in that said conductive paths (47 to 54, 83, 84, 86; 87 of 89 and 90; 87 of 109 and 110) are so arranged as to constitute a strip-line construction (37, 38, 39) wherein conductive paths (37, 39; 47 to 54, 83, 84, 86; 87 of 89 and 90; 87 of 109 and 110) forming the capacitive element (105, 106) at least in part are identical with conductive paths (37, 39; 47 to 54, 83, 84, 86; 87 of 89 and 90; 87 of 109 and 110) forming the inductive element (103, 104).

2. The device according to claim 1, characterised in that said conductor paths (47 to 54, 83, 84, 86; 87 of 89 and 90, 87 of 109 and 110) are so arranged that upon unfolding mutually superposed conductor path parts (47, 53; 49, 51; 48, 54; 50, 52; 53, 54; 87 of 89, 87 of 90; 87 of 109, 87 of 110) into a common plane segments of conductor paths (47, 48; 49, 50; 51, 52; 53, 54; 87 of 89, 87 of 90; 87 of 109, 87 of 110) are substantially arranged in a center symmetrical relationship with respect to one another, the reference point (35) of which relationship being located on an axis (36; 92, 111) about which said conductor path parts (47, 48; 49, 50; 51, 52; 53, 54; 87 of 89, 87 of 90; 87 of 109, 87 of 110) have been folded.

3. The device according to claim 1 or 2, characterised in that conductor paths (47 to 54, 83, 84, 86) form connected patterns (31, 32, 33, 34) wherein said conductor paths are so arranged that—when developing said connected patterns in a single plane—in any case those patterns (32, 33) form a substantially meander-shaped path route (49, 86, 50) which patterns connect, along two of their margins, to adjacent patterns (31, 33; 32, 34).

4. The device according to claim 3, characterised in that in terminal patterns (31, 34), which single-end connect to adjacent patterns (32, 33), conductor paths (47, 53, 83; 48, 54, 84) form spiral paths which turn at least once with same turn direction.

5. The device according to one of claims 1 to 4, characterised in that conductor paths (47 to 54, 83, 84, 86; 87 of 89 and 90; 87 of 109 and 110) in mutually superposed planes have different shapes and/or dimensions, particularly different path widths.

6. The device according to claim 5, characterised in that conductor paths (partial patterns 31 to 34) are arranged in at least three mutually superposed planes and that conductor paths having larger dimensions are provided in the two outermost planes and conductor paths having smaller dimensions are so provided between said outermost planes that they are electrostatically shielded by the conductor paths provided in said outermost planes.

7. The device according to one of claims 1 to 6, characterised in that conductor path segments (partial patterns 32, 33) having a low electrical impedance are provided on outer faces of conductor path segments (partial pattern 31, 34) having a high electrical impedance.

8. The device according to claim 1, characterised in that conductor paths (87) are arranged in two planar conductor path patterns (89, 90; 109, 110) having the shape of spiral paths (89, 90; 109, 110) each of which having a plurality of turns which counter-turn with respect to each other, if viewed from the same side, in an aligned turn-to-turn superposition.

9. The device according to claim 8, characterised in that the dielectric has at least the shape of one spiral path (88 of 109) which superposes one conductor path pattern (87, 109) and turns with the turn direction of said superposed conductor path pattern.

10. The device according to claim 8, characterised in that the dielectric (88) fills at least an area defined by the common outline of two mutually superposing spiral paths (89, 90; 109, 110), which spiral paths—if viewed from the same side—counter-turn with respect to each other betewen conductor paths (87 of 89, 87 of 90; 87 of 109, 87 of 110).

11. The device according to claim 8, characterised in that the dielectric (88; 93; 81) existing between mutually superposed conductor paths (87 of 89, 90; 87 of 109, 110) has a greater average filling compactness or total thickness than does have the dielectric (93; 81) which exists—exterior to zones of superposition—within lateral spacings between adjacent stripline turns.

12. The device according to one of the preceding claims, characterised in that a dielectric tuning element (81) is spaced between two mutually superposed conductor path segments (80; 112, 113), the position of which element being adjustable with respect to said conductor path segments (80; 112, 113), whereby preferably said dielectric tuning element (81) is coooperative with capacitive tuning areas formed of conductor path segments (80; 112, 113), the shape of which tuning areas being so selected with respect to an adjustment direction of said dielectric tuning element (81) that, in response to a displacement of the latter between two mutually superposed adjustment areas in the adjustment direction, the adjustment capacitance effected by said adjustment areas and said dielectric adjustment element (81) varies, versus the degree of said displacement, according to a predetermined function.

13. The device according to one of claims 1 to 12, characterised in that a dielectric material (40, 41, 42; 81, 93) forming at least a partial layer between mutually superposed conductor path patterns (31, 32, 33, 34; 89, 90; 109, 110) extends also over the center region of the device which is not occupied by conductor paths.

14. The device according to one of the preceding claims, characterised in that at least two mutually superposed terminal segments (47, 48; 83, 84; 89, 90; 109, 110) of conductor path patterns (31, 34; 89, 90; 109, 110) which latter form at least one spiral turn are designed with greater areas per length than are designed all other conductor path segments of said conductor path patterns.

15. The device according to claim 8, characterised in that counter-turning spiral turns (87 of 89 and 90) are open ended towards the center of said conductor path patterns, with no particular capacitive areas provided for termination.

16. The device according to claim 8, characterised in that said planar conductor path patterns (89, 90) are conductively connected with each other so that spirally routing conductor paths (87 of 89 and 87 of 90) in a series connection relationship turn round with a substantially uniform turn direction.

17. The device according to one of claims 1 to 16, characterised in that the conductor paths (47 to 54, 83, 84, 86; 87 of 89, 90; 87 of 109, 110) are provided on a flexible, electrically insulative carrier sheet (56), said sheet particularly being made from a dielectric material, and wherein said carrier sheet (56) and/or conductor paths (107, 108) are fitted with perforations (57 to 59, 71, 92, 102, 111) and/or positive folding lines for marking foldlines (36, 43, 44, 92).

18. The device according to one of claims 1 to 17, characterised in that said conductor paths (47 to 54, 83, 84, 86; 87 of 89, 90; 87 of 109, 110) are embedded in a paper- or cardboard-like cover material (165) having a carrier function.

19. The device according to one of claims 17 and 18, characterised in that the device (118, 122) is provided with a punched hole (119, 125) in its inner region which is not occupied by conductor paths (47 to 54, 83, 84, 86; 87 of 89, 90; 87 of 109, 110).

20. Method for the production of a tag-shaped identification device affixable to an object and comprising at least an inductive element formed of planar conductor paths and a capacitive element formed of mutually superposed conductor paths and a dielectric spaced therebetween and forming, in cooperation with said inductive element, a resonant circuit, characterised in that an arrangement of conductor paths (30, 89, 90, 91, 109, 110) which can be developed in a single plane is subjected to folding about at least one foldline (36, 43, 44, 92, 111) in a manner so that a dielectric (38, 40 to 42, 45, 46, 88, 93) becomes arranged between at least two mutually counterfolded conductor path parts (47 to 54, 83, 84, 86, 87 of 89 and 90, 87 of 109 and 110).

21. The method according to claim 20, characterised in that conductor paths (47 to 54, 83, 84, 86; 89, 90; 109, 110) at least in part are provided with a coat made from an adhesive (62) and that said adhesive (62) is subjected to a selective activation under the influence of pressure and/or heat.

22. The method according to one of claims 20 and 21, characterised in that in succession a plurality of identification devices is provided on a strip-like flexible carrier sheet (56, 65a).

23. The method according to one of claims 20 to 22, characterised in that conductor path structures (31, 32, 33, 34; 47 to 54; 83, 84, 86; 89, 90; 109, 110) having mutually superposing conductive and dielectric paths are being produced from a dielectrically (38; 45, 46; 88) precoated metal foil (7), particularly by way of cutting or punching.

24. The method according to one of claims 20 to 23, characterised in that—in an endless succession—a multiplicity of identification devices (70) is provided with an adhesive film (72) and severing perforations (72) and arranged on a strip-like flexible carrier sheet (73), and that said carrier sheet (73)—together with said identification devices (70) provided thereon—is being wound up so as to form a supply roll.

25. The use of the identification device according to one of claims 1 to 19, characterized in that the identification device (70; 100; 118, 122) is operated as an essential part of an electronic system for the detection of theft actions on goods or for personal access control purposes.

26. The use of the identification device according to claim 25, characterised in that the identification device (70; 100; 118; 122) is arranged on/within objects (117, 121) or on/within a preprinted merchandise tag (97) fitted with a face material which suits for carrying data.

27. The use of the identification device according to claim 26, characterised in that said merchandise tag (97) comprises a customer section (99) and a cashier section (98), both sections separably joining each another, and that the identification device (100) is provided at least with one of both sections (98, 99).

28. The use of the identification device according to one of claims 25 to 27, characterised in that the identification device is being punched in a suitable place for thus being rendered inoperative.

Fig. 1

Fig. 2

Fig. 3

Fig. 4

Fig. 5

49

Fig. 6

35

47

48

50

56          61          62

31

32

33

34

57

59

58

Fig. 7

EP 0 092 555 B1

Fig. 8

Fig. 9

4

Fig. 11

Fig 12

82

79 62 79

79

59

80 81 80 59

Fig. 10

85

83 86 84

Fig. 13

6

**Fig. 14**

**Fig. 15**

**Fig. 16**

FIG. 17

FIG. 18

FIG. 20

Fig. 21

Fig. 19

EP 0 092 555 B1

Fig. 22

Fig. 23

10